# EUROPEAN PATENT APPLICATION

(11) **EP 2 775 534 A1**
(43) Date of publication of application: **10.09.2014**
(21) Application number: 14156983.0
(22) Date of filing: 27.02.2014
(51) Int. Cl.: H01L 31/032, C23C 14/00, H01L 21/02, H01L 31/18

(54) **Film forming device for solar cell**

(30) Priority: 04.03.2013 KR 20130022989
(71) Applicant: Samsung SDI Co., Ltd., Yongin-si, Gyeonggi-do (KR)
(72) Inventor: Kim, In-Ki, Gyeonggi-do (KR); Ahn, Dong-Gi, Gyeonggi-do (KR); Kim, Byoung-Dong, Gyeonggi-do (KR); Lee, Seung-Jin, Gyeonggi-do (KR); Kishimoto, Katsushi, Gyeonggi-do (KR)
(74) Representative: Walaski, Jan Filip

(57) **Abstract**

A film forming device for a solar cell includes a chamber including a body configured to receive a substrate, the chamber defining a hollow portion, a heating device at the hollow portion, and a heat insulating member for surrounding the substrate and the heating device.

## Description

The described technology relates generally to a film forming device for a solar cell.

A thin film solar cell is one type of solar cell, and uses a chamber to form a constituent element, such as a light absorbing layer.

For example, in a copper-indium-gallium-selenide (hereafter referred to as CIGS) solar cell, a light absorbing layer may be formed through heat treatment at a high temperature after a substrate formed with a precursor is inserted inside a chamber. However, there are many problems in managing the chamber used to manufacture the thin film solar cell, such as a CIGS (CuInGaSe2) solar cell.

The described technology provides a film forming device for a solar cell including a configuration for reducing or preventing corrosion of an inner wall of a chamber caused by heat generated during a thin film deposition process.

Embodiments of the present invention provide a film forming device for a solar cell including a configuration for reducing or preventing deposition of selenium on an inner wall of a chamber when a thin film deposition process is finished.

Embodiments of the present invention provide a film forming device for a solar cell including a configuration for reducing a time for cooling a chamber when a thin film deposition process is finished.

An exemplary embodiment of the present invention provides a film forming device for a solar cell including a chamber including a body configured to receive a substrate, the chamber defining a hollow portion, a heating device at the hollow portion, and a heat insulating member for surrounding the substrate and the heating device.

### The chamber may include metal.

The heat insulating member may be between the heating device and an inner side of the body of the chamber.

The hollow portion may be configured to receive the substrate on a substrate loading device.

The heating device may be between the substrate loading device and an inner side of the body of the chamber.

The heating device may include a first heater and a second heater at the hollow portion of the body of the chamber, and may have a gap therebetween.

The first heater and the second heater may be configured to receive the substrate loading device therebetween.

The heat insulating member may include a first heat insulator between the first heater and the inner side of the body, a second heat insulator between the second heater and the inner side of the body, and a third heat insulator coupling the first heat insulator and the second heat insulator.

The device may be configured to deposit on the substrate including glass.

The film forming device may further include a protecting member coupled to an outer side of the body.

The film forming device may further include an auxiliary heating device between an inner side of the protecting member and the outer side of the body.

The auxiliary heating device may include a plurality of auxiliary heaters.

The film forming device may further include a cooling device coupled to the protecting member and configured to supply a coolant into a space between the inner side of the protecting member and the outer side of the body.

The cooling device may include a cooling device body, a coolant supply duct coupling the cooling device body to the protecting member, and configured to transmit the coolant into the space between the inner side of the protecting member and the outer side of the body, and a coolant discharge duct for coupling the protecting member to the cooling device body, and configured to discharge the coolant to the cooling device body.

The film forming device may further include a coolant scattering member between the inner side of the protecting member and the auxiliary heating device.

The coolant scattering member may be between a coolant supply inlet of the coolant supply duct and the auxiliary heating device.

The device may be configured to maintain a temperature inside the body of the chamber at about 250 °C to about 500 °C when a thin film is deposited on the substrate.

Accordingly, an embodiment of the present invention provides the film forming device for a solar cell including a configuration for reducing or preventing corrosion of an inner wall of a chamber caused by heat that is generated during a thin film deposition process.

Further, an embodiment of the present invention provides the film forming device for a solar cell including a configuration for reducing or preventing deposition of selenium on an inner wall of a chamber when a thin film deposition process is finished.

In addition, an embodiment of the present invention provides the film forming device for a solar cell including a configuration for reducing a time for cooling a chamber when a thin film deposition process is finished.

Embodiments of the invention will now be described by way of example with reference to the accompanying drawings, in which:
FIG. 1 shows an exploded perspective view of a film forming device for a solar cell according to a first exemplary embodiment of the present invention.
FIG. 2 shows a cross-sectional view of the film forming device of FIG. 1 with respect to the line II-II.
FIG. 3 shows a cross-sectional view of a film forming device of a solar cell according to a second exemplary embodiment of the present invention.
FIG. 4 shows a perspective view of a film forming device for a solar cell according to a third exemplary embodiment of the present invention.
FIG. 5 shows a cross-sectional view of the film forming device of FIG. 4 with respect to the line V-V.
FIG. 6A shows an image of an inner side of a chamber before a film forming deposition process is performed.
FIG. 6B shows an image of an inner side of a chamber that is not corroded after a thin film deposition process is performed according to the third exemplary embodiment of the present invention.
FIG. 6C shows an image of an inner side of a chamber that is corroded after a thin film deposition process by a conventional film forming device for a solar cell is performed.
FIG. 7A shows an image of an inner side of a chamber before a film forming deposition process is performed.
FIG. 7B shows an image of an inner side of a chamber to which selenium (Se) is not deposited after a thin film deposition process is performed according to the third exemplary embodiment of the present invention.
FIG. 7C shows an image of an inner side of a chamber to which selenium (Se) is deposited after a thin film deposition process by a conventional film forming device for a solar cell is performed.
FIG. 8 shows a graph of a cooling rate of a chamber after a thin film deposition process according to the third exemplary embodiment of the present invention is performed.
FIG. 9 shows a cross-sectional view of a film forming device for a solar cell according to a fourth exemplary embodiment of the present invention.

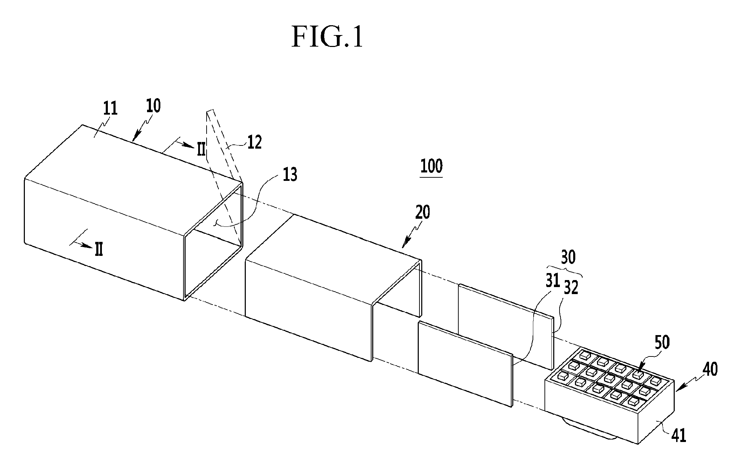

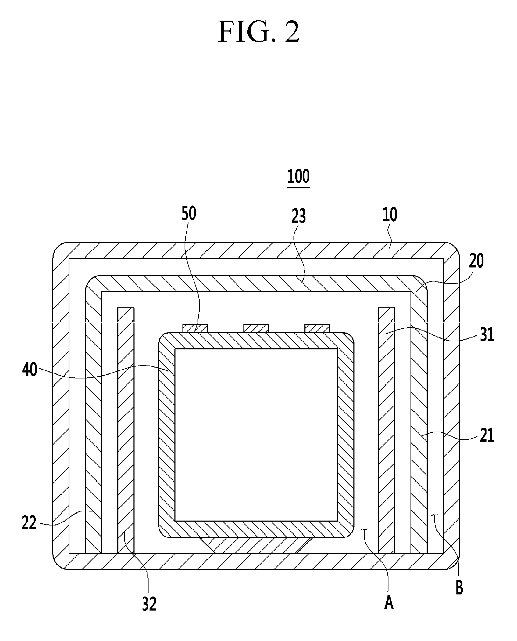

FIG. 1 shows an exploded perspective view of a film forming device for a solar cell according to a first exemplary embodiment of the present invention, and FIG. 2 shows a cross-sectional view of the film forming device of FIG. 1 with respect to the line II-II.

Referring to FIG. 1 and FIG. 2, the film forming device 100 for a solar cell includes a chamber 10, a heating device 30 installed inside the chamber, a substrate loading device 40 at which a substrate 50 may be installed, and which may be received inside the chamber 10, and a heat insulating member 20 installed in the chamber 10.

Here, the film forming device 100 can form a thin film or a thick film on the substrate 50. For convenience of description, formation of a thin film on the substrate 50 will now be described.

The chamber 10 includes a hollow portion of a body 11, a door 12, and an opening 13 that may be covered by the door 12. The chamber 10 may be closed and sealed by the door 12 covering the opening 13, and may be operated when closed and sealed without any inflow of exterior air.

The chamber 10 may be made of a metal. Such a metal may be one of, for example, corrosion-resistant metals including stainless steel, carbon steel, and aluminum, or one of superalloys including INCONEL, or INCONEL alloy (INCONEL is a registered trademark of Huntington Alloys Corporation), a nickel alloy, or a copper alloy.

Also, the body 11 of the chamber 10 includes a pair of side walls, and sides for connecting the side walls. A cross-section of the body 11 may be quadrangular, although the cross-section of the body 11 is not limited to the quadrangular shape of the present embodiment, and it may be, for example, circular or hexagonal.

The body 11, which may be made of metal, may be problematically corroded by a compound of copper (Cu), indium (In), gallium (Ga), and selenium (Se), which may be placed in the hollow portion of the body 11 and may be heated to be deposited on the substrate installed in the body 11. Accordingly, applying a corrosion resistance process to the inner side of the body 11 may reduce or prevent corrosion caused by a compound of copper (Cu), indium (In), gallium (Ga), and selenium (Se).

For example, the inner side of the body 11 may have a sacrificial electrode including a material that is coated thereon, or having a high ionization tendency.

In the present embodiment, the inner side of the body 11 may be coated with a corrosion-resistant material that is about 1 µm to about 2 µm thick by using, for example, chemical deposition, sputtering, or thermal spraying. However, the coating of the inner side of the body 11 is not restricted to particular coating methods such as chemical deposition, sputtering, or thermal spraying, and the inner side of the body 11 may be covered with a corrosion-resistant material that is about 1 mm thick or greater. Also, the body 11 may be made of a corrosion-resistant material.

Further, the chamber 10 may be made of quartz. However, when the chamber includes quartz as a main material, the size of the original quartz may be restricted, and it may be difficult to produce a large chamber. Further, the quartz chamber is typically made circular because of rigidity. Therefore, using a metal as the main material for the chamber may make it relatively easier to manufacture a large chamber.

The heat insulating member 20 may be installed between the heating device 30 and the inner side of the body 11 of the chamber 10. The heating device 30 may include a first heater 31 and a second heater 32 that are installed at facing/opposite sides of the substrate loading device 40 (e.g., when the substrate loading device 40 is received in the hollow portion of the body 11).

Therefore, when the heating device 30 is driven, and when selenium (Se) is supplied to the interior of the chamber 10, the selenium (Se) may react with the substrate 50 to which copper (Cu), indium (In), and gallium (Ga) are deposited, and the selenium (Se) may be deposited to the substrate 50. In embodiments of the present invention, the substrate 50, to which precursors, such as copper (Cu), indium (In), and gallium (Ga), are deposited, may be made of, for example, one of glass, aluminum foil, stainless steel, or plastic.

The inside of the body 11 may be heated by the heating device 30, which may be coupled to a control device, and the temperature inside the body 11 and/or the temperature of an inner side of the body 11 may be increased to about 500 °C. Accordingly, the heat insulating member 20 located between the inner side of the body 11 and the heating device 30 can absorb, block, or insulate, the heat transferred to the inner side of the body 11 of the chamber 10 from the heating device 30.

For example, the heat insulating member 20 may include a first heat insulator 21 and a second heat insulator 22 respectively between the inner side of the body 11 and the first heater 31 and between the inner side of the body 11 and the second heater 32, and may also include a third heat insulator 23 for coupling the first and second heat insulators 21 and 22, and located above the substrate transferring device 40 received in the hollow portion of the body 11. In the present embodiment, the heat insulating member 20 may be made of, for example, one of a ceramic insulator, a carbon-based insulator, or an insulator using an air layer.

In the present embodiment, the inside of the body 11 of the chamber 10 includes a first part (A) that is wrapped/surrounded by the heat insulating member 20, and on which the heating device 30 and the substrate loading device 40 are provided, and a second part (B) between the inner side of the body 11 of the chamber 10 and the heat insulating member 20. In the present embodiment, the temperature and pressure of the first part (A) and the second part (B) may be respectively or independently controllable by a control device.

Therefore, because heat transferred to the inner side of the body 11 from the heating device 30 is insulated by the heat insulating member 20, when a temperature of a thin film of the first part (A) inside the body 11 is increased to a temperature that the thin film may be deposited to the substrate 50 (e.g., increased to about 500 °C), a temperature of the second part (B) may, nonetheless, be maintained at a temperature that is less than the temperature of the first part (A) (e.g., about 250 °C to about 500 °C).

Resultantly, during the process for depositing the thin film, heat transferred to the inner side of the body 11 from the heating device 30 is reduced, and corrosion of the inner side of the body 11 that may be caused by heat is reduced.

Further, because heat is intercepted, or blocked, by the heat insulating member 20 during the process for depositing the substrate 50, the heat insulating member 20 of the present embodiment effectively reduces or prevents deposition of selenium (Se) powder to the body 11, which would possibly otherwise occur at the first part (A). Accordingly, deposition of the selenium (Se) powder to the inner side of the body 11 through the second part (B) is reduced or prevented.

As a result, unwanted deposition of a thin film on the substrate 50 during a new thin film deposition process is reduced or prevented by reducing or preventing deposition of the selenium, which remains inside the body 11, to the inner side of the body 11.

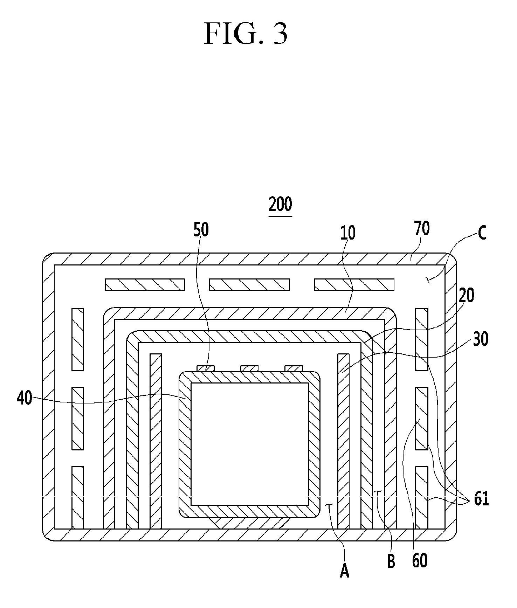

FIG. 3 shows a cross-sectional view of a film forming device of a solar cell according to a second exemplary embodiment of the present invention. Referring to FIG. 3, the film forming device 200 according to the second exemplary embodiment of the present invention is similar to the film forming device 100 of the first exemplary embodiment of the present invention, with differences including the presence of an auxiliary heating device 60 and a protecting member 70. Therefore, similarities to the film forming device 100 according to the first exemplary embodiment of the present invention will not be repeated.

In the present embodiment, the film forming device 200 may form a thin film or a thick film on the substrate 50. For convenience of description, formation of a thin film on the substrate 50 will be described.

Regarding the auxiliary heating device 60 and the protecting member 70, the auxiliary heating device 60 is installed at a third space (C) between an outer side of the body 11 and an inner side of the protecting member 70. In the present embodiment, the protecting member 70 may be combined with an outer wall of the chamber 10. Further, the auxiliary heating device 60 may include a plurality of auxiliary heaters 61 that are installed at regular intervals at the third space (C).

In the present embodiment, the auxiliary heating device 60 may be coupled to a control device to be controlled by the same, and temperatures and pressures of the first space (A), the second space (B), and the third space (C) may be controllable by the control device.

Therefore, when a thin film is deposited to the substrate 50, the temperature of the first space (A) and the inner side of the body 11 of the chamber 10 may be maintained (e.g., at about 250 °C to about 500 °C), thereby reducing or preventing the amount of selenium (Se) powder that is deposited on inner walls of the body 11.

For example, because the heat generated by the heating device 30 is insulated by the heat insulating member 20, the first space (A) may be maintained at the temperature at which the selenium (Se) powder is not generated (e.g., about 250 °C to about 500 °C), while the second space (B) can reach a lower temperature at which the selenium powder may be generated (e.g., about 200 °C to about 250 °C).

In the present embodiment, when the control device senses that the third space (C) reaches a temperature at which the selenium (Se) powder may be deposited to the inner side of the body 11 (e.g., about 200 °C to about 250 °C), the control device may operate the auxiliary heating device 60 to increase heat at the inner side of the body 11 to reach the temperature (e.g., about 250 °C to about 500 °C) at which the selenium (Se) powder cannot/is less likely to be generated.

Therefore, because the inside of the body 11 and the inner side may be maintained at the temperature at which the selenium (Se) powder is not generated/deposited (e.g., about 250 °C to about 500 °C), the selenium (Se) powder is not generated at the third space (C) and the selenium (Se) is not deposited at the inner side of the body 11.

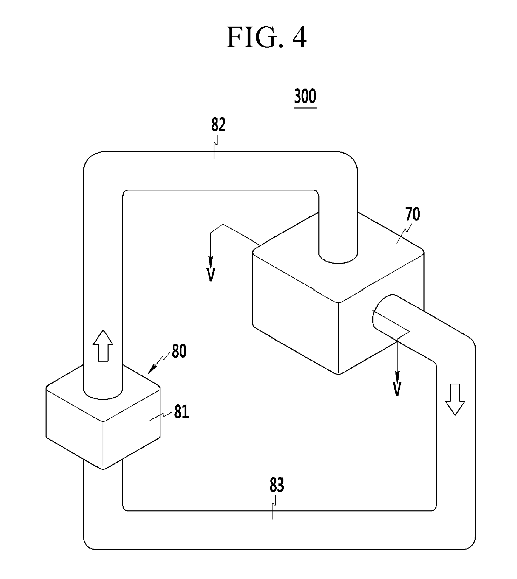

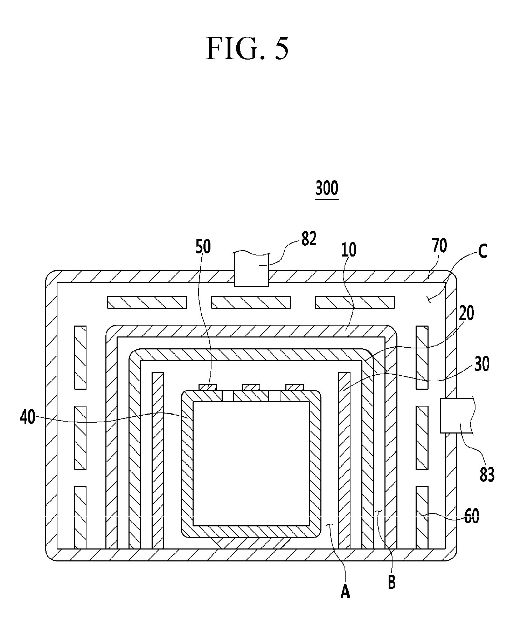

FIG. 4 shows a perspective view of a film forming device for a solar cell according to a third exemplary embodiment of the present invention, and FIG. 5 shows a cross-sectional view of the film forming device of FIG. 4 with respect to the line V-V. Referring to FIG. 4 and FIG. 5, the film forming device 300 for a solar cell according to the third exemplary embodiment of the present invention is similar to the film forming device 200 for a solar cell according to the second exemplary embodiment of the present invention, with a difference being the presence of a cooling device 80. Similarities to the film forming device 200 for a solar cell according to the second exemplary embodiment of the present invention will not be repeated.

Here, the film forming device 300 may form a thin film or a thick film on the substrate 50. For convenience of description, formation of a thin film on the substrate 50 will now be described.

As shown in FIG. 4 and FIG. 5, the cooling device 80 includes a cooling device body 81, a coolant supply duct 82, and a coolant discharge duct 83. In the present embodiment, the cooling device 80 may be coupled to a control device to be controlled by the same.

Further, the coolant supply duct 82 includes a first end coupled to the cooling device body 81, and a second end coupled to the protecting member 70. Therefore, a coolant (e.g., air) is supplied to the third space (C) through the coolant supply duct 82 by the cooling device 80.

Further, the coolant discharge duct 83 includes a first end coupled to the protecting member 70, and a second end coupled to the cooling device body 81. Therefore, the coolant (e.g., air) supplied to the third space (C) through the coolant supply duct 82 may be discharged to the cooling device 80 through the coolant discharge duct 83. Accordingly, the temperature of the third space (C) may be maintained by the cooling device 80.

In detail, the first space (A), the second space (B), and the third space (C) may be closed and sealed (e.g., completely blocked from the outside). Accordingly, temperatures and pressures of the first space (A), the second space (B), and the third space (C) may be controlled by a control device.

Therefore, heat may be supplied to the third space (C), and the temperature of the third space (C) may increase to be greater than a given temperature (e.g., about 500 °C), and the heat supplied to the first space (A) and the second space (B) by the heating device 30, which corresponds to the temperatures of the inner wall and the outer wall of the chamber 10, may be controlled to maintain the temperature at which the selenium (Se) powder is not generated (e.g., about 250 °C to about 500 °C) during the thin film deposition process.

In the present embodiment, when the temperature of the third space (C) becomes greater than a given temperature (e.g., about 500 °C), the cooling device 80 is driven by the control device. Therefore, the coolant (e.g., air) may be supplied from the cooling device 80 to the third space, which is between the outer wall of the chamber 10 and the inner wall of the protecting member 70, through the coolant supply duct 82. The coolant (e.g., air) may be supplied through the coolant supply duct 82 until the temperature of the third space (C) becomes less than a temperature (e.g., about 500). Further, the coolant (e.g., air) supplied to the third space (C) enters and passes through the third space (C), goes through the coolant discharge duct 83, and is discharged outside the protecting member 70.

Therefore, the temperature of the inner side of the body 11 may be maintained to be less than a temperature to reduce or prevent overheating and corrosion of the inner side of the body 11 (e.g., about 500 °C).

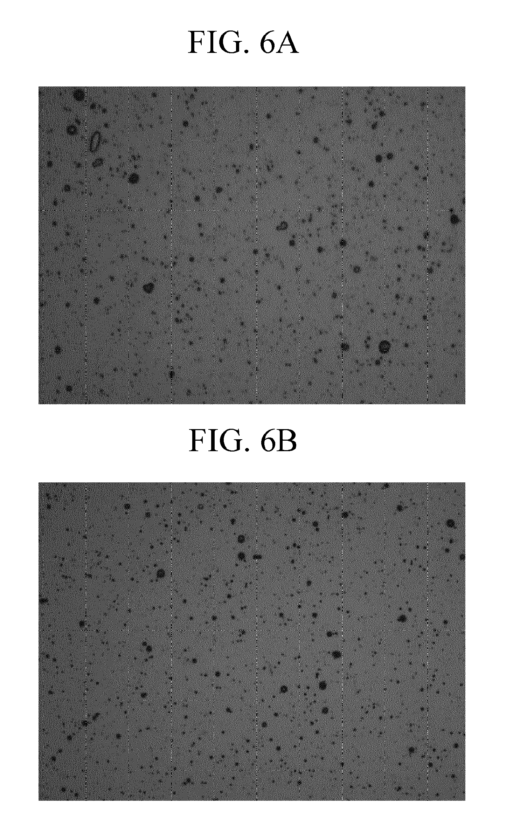

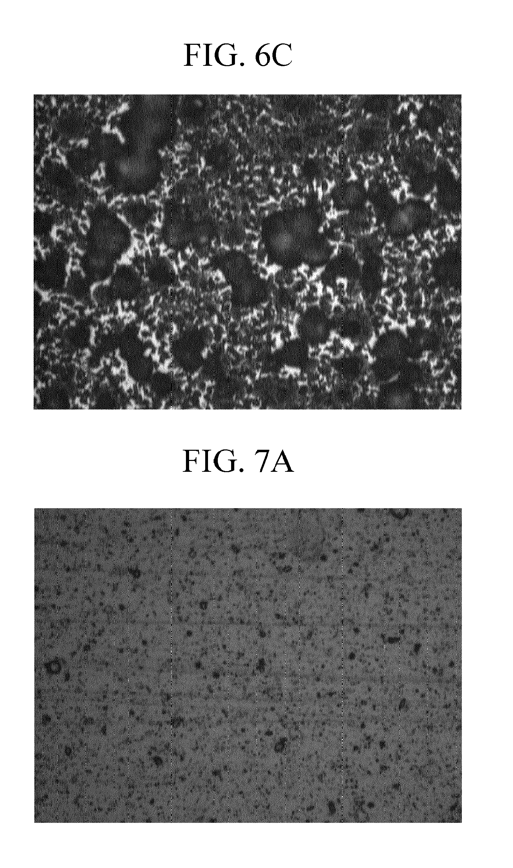

FIG. 6A shows an image of an inner side of a chamber before a film forming deposition process is performed, and FIG. 6B shows an image of an inner side of a chamber that is not corroded after a thin film deposition process is performed according to the third exemplary embodiment of the present invention. FIG. 6C shows an image of an inner side of a chamber that is corroded after a thin film deposition process by a conventional film forming device for a solar cell is performed.

When images of the inner side of the body 11 before and after the thin film deposition process is performed (e.g., FIG. 6A and FIG. 6B) are compared, it is found that the inner side of the body 11 is not corroded after the thin film deposition process of FIG. 6B is performed.

However, by comparing images of the inner side of the body before and after the thin film deposition process according to the *conventional* film forming device for a solar cell is performed (e.g., FIG. 6A and FIG. 6C), it is found that the inner side of the body 11 after the thin film deposition process according to the conventional film forming device for a solar cell (e.g., of FIG. 6C) is corroded, and a substantial part of the inner side thereof is damaged.

Therefore, referring to FIGS. 6A to 6C, overheating of the inner side of the body 11 is reduced or prevented by the cooling device 80, and, resultantly, the inner side of the body 11 is not corroded after the thin film deposition process is performed. Further, it is possible to maintain the inner side of the body 11 at the temperature at which the selenium (Se) powder is not generated (e.g., about 250 °C to about 500 °C).

In detail, temperatures and pressures of the first space (A), the second space (B), and the third space (C) may be controlled by a control device. The first space (A) may be maintained at the temperature at which the selenium (Se) powder is not generated (e.g., about 250 °C to about 500 °C) using the heating device 30, and the second space (B) can reach the temperature at which selenium (Se) powder may be generated (e.g., 200 °C-250 °C), because unwanted transmission of the heat generated by the heating device 30 (e.g., transmission of the heat into the second space (B)) may be blocked by the heat insulating member 20.

In the present embodiment, the auxiliary heating device 70 at the third space (C) may be operated to control the temperature of the second space to be at the temperature at which the selenium (Se) powder is not generated and is not deposited to an inner side of the body 11 (e.g., about 250 °C to about 500 °C).

Therefore, when a hollow portion of the body 11 and the inner side of the body 11 are maintained at the at which selenium (Se) powder is not generated and deposited temperature (e.g., about 250 °C to about 500 °C), generation of the selenium (Se) powder at the hollow portion of the body 11 after the thin film deposition process is performed is reduced or prevented, and deposition of the selenium (Se) powder to the inner side of the body 11 is reduced or eliminated.

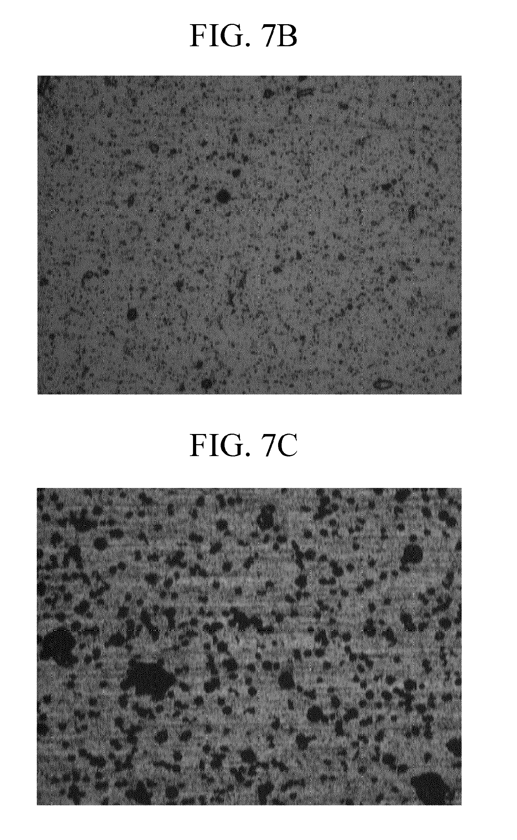

FIG. 7A shows an image of an inner side of a body 11 before a film forming deposition process is performed, and FIG. 7B shows an image of an inner side of a body 11 to which selenium (Se) is not deposited after a thin film deposition process is performed according to the third exemplary embodiment of the present invention. FIG. 7C shows an image of an inner side of a body 11 to which selenium (Se) is deposited after a thin film deposition process by a conventional film forming device for a solar cell is performed.

When images of the inner side of the body 11 before and after the thin film deposition process according to the third exemplary embodiment of the present invention are compared (e.g., FIGS. 7A and 7B), it can be seen that little to no selenium (Se) is deposited to the inner side of the body 11 after the thin film deposition process of FIG. 7B is performed.

However, when images of the inner side of the body before and after the thin film deposition device process according to the *conventional* film forming device for a solar cell are compared (e.g., FIGS. 7A and 7B), it is found that a substantial amount of selenium (Se) is deposited to the inner side of the body after the thin film deposition process by the conventional film forming device for a solar cell of FIG. 7C is performed.

Therefore, referring to FIG. 7A to FIG. 7C, deposition of the selenium (Se) to the inner side of the body 11 is reduced or prevented by maintaining the inner side of the body 11 at the temperature at which the selenium (Se) powder is not generated and is not deposited (e.g., about 250 °C to about 500 °C).

Further, an entire processing time for the thin film deposition process may be reduced by reducing a time for cooling the chamber 10 after the thin film deposition process is performed. For example, the temperature of the hollow portion of the body after the thin film deposition process is finished may, conventionally, be slowly reduced from about 500 °C. Therefore, a relatively lengthy amount of time may pass for the temperature inside the body to reach an appropriate temperature for removing the substrate, on which the thin film is deposited, from the substrate loading device. For example, according to the *conventional* film forming device for a solar cell, it takes about eight hours for the temperature inside the body to reach the appropriate temperature (e.g., about 15 °C) at which the substrate loading device is moved outside the chamber to remove the deposition-finished substrate from the substrate loading device.

In the present embodiment, after the thin film deposition process in the chamber 10 is finished, the cooling device 80 may supply a coolant to the third space (C), which is located between the outer side of the body 11 and the inner side of the protecting member 70, via the coolant supply duct 82 to cool the body 11. Further, the coolant that is heated in the third space (C) is discharged to the outside through the coolant discharge duct 83. Therefore, the body 11 may be forcibly cooled using the cooling device 80, thereby causing the time for cooling the body 11 after the thin film deposition process is finished to be reduced, and also causing the overall time for the thin film deposition process to be reduced.

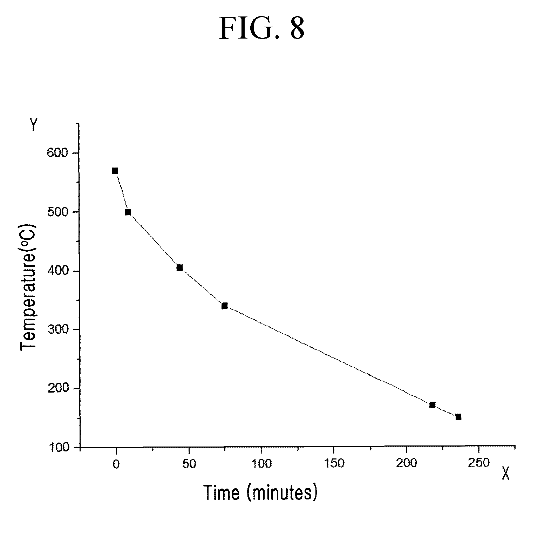

FIG. 8 shows a graph of a cooling rate of a chamber after a thin film deposition process according to the third exemplary embodiment of the present invention is performed. Referring to FIG. 8, when a thin film deposition process is performed in a hollow portion of the body 11 of the film forming device 300 for a solar cell, the temperature of the hollow portion of the body 11 is increased to reach about 500 °C.

Further, when the cooling device 80 is driven, about four hours pass until it reaches the temperature (e.g., about 150 °C) at which the substrate loading device 40 should be removed from the chamber 10 after a thin film is deposited to the substrate 50. Accordingly, the cooling device 80 may be operated after the thin film is deposited to the substrate 50 to thereby reduce the entire processing time for the thin film deposition process.

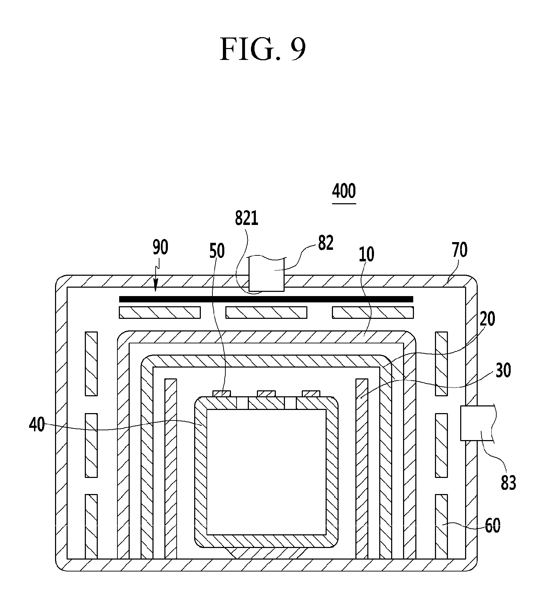

FIG. 9 shows a cross-sectional view of a film forming device for a solar cell according to a fourth exemplary embodiment of the present invention. Referring to FIG. 9, the film forming device 400 for a solar cell is similar to the film forming device 300 of the third exemplary embodiment of the present invention, with the exception of the presence of a coolant scattering member 90. Therefore, similarities to the film forming device 300 for a solar cell according to the third exemplary embodiment of the present invention will not be repeated.

In the present embodiment, the film forming device 400 forms a thin film or a thick film on the substrate 50. For convenience of description, formation of a thin film on the substrate 50 will now be described.

The coolant scattering member 90 is formed as a thin plate shape with a constant thickness. Further, the coolant scattering member 90 is installed at the third space (C) between the outer wall of the chamber 10 and the inner wall of the protecting member 70. In detail, the coolant scattering member 90 may be installed between the auxiliary heating device 60 and a coolant supply inlet 821 of the coolant supply duct 82 of the cooling device 80 installed at the third space (C).

Therefore, when the coolant (e.g., air) transmitted from the cooling device 80 through the coolant supply duct 82 enters the third space (C) through the coolant supply inlet 821, the coolant is led to respective ends of the coolant scattering member 90 to scatter the coolant in the third space (C). Resultantly, according to the coolant scattering member 90, the coolant is more uniformly scattered in the third space (C) to thus efficiently cool the chamber 10.

While the present invention has been described in connection with what is presently considered to be practical exemplary embodiments, it is to be understood that the invention is not limited to the disclosed embodiments, but, on the contrary, is intended to cover various modifications and equivalent arrangements included within the scope of the appended claims.

## Claims

1. A film forming device for a solar cell, the device comprising:
a chamber comprising a body configured to receive a substrate, the chamber defining a hollow portion;
a heating device at the hollow portion; and
a heat insulating member for surrounding the substrate and the heating device.

2. The film forming device of claim 1, wherein the chamber comprises metal.

3. The film forming device of claim 1 or 2, wherein the heat insulating member is between the heating device and an inner side of the body of the chamber.

4. The film forming device of claim 1, 2 or 3, wherein the hollow portion is configured to receive the substrate on a substrate loading device.

5. The film forming device of claim 4, wherein the heating device is between the substrate loading device and an inner side of the body of the chamber.

6. The film forming device of claim 5, wherein the heating device comprises a first heater and a second heater at the hollow portion of the body of the chamber, and having a gap therebetween.

7. The film forming device of claim 6, wherein the first heater and the second heater are configured to receive the substrate loading device therebetween.

8. The film forming device of claim 6, wherein the heat insulating member comprises:
a first heat insulator between the first heater and the inner side of the body;
a second heat insulator between the second heater and the inner side of the body; and
a third heat insulator coupling the first heat insulator and the second heat insulator.

9. The film forming device of any one of the preceding claims, wherein the device is configured to deposit on the substrate comprising glass.

10. The film forming device of any one of the preceding claims, further comprising a protecting member coupled to an outer side of the body.

11. The film forming device of claim 10, further comprising an auxiliary heating device between an inner side of the protecting member and the outer side of the body, wherein the auxiliary heating device may comprise a plurality of auxiliary heaters.

12. The film forming device of claim 11, further comprising a cooling device coupled to the protecting member and configured to supply a coolant into a space between the inner side of the protecting member and the outer side of the body.

13. The film forming device of claim 12, wherein the cooling device comprises:
a cooling device body;
a coolant supply duct coupling the cooling device body to the protecting member, and configured to transmit the coolant into the space between the inner side of the protecting member and the outer side of the body; and
a coolant discharge duct for coupling the protecting member to the cooling device body, and configured to discharge the coolant to the cooling device body.

14. The film forming device of claim 13, further comprising a coolant scattering member between the inner side of the protecting member and the auxiliary heating device, wherein the coolant scattering member may be between a coolant supply inlet of the coolant supply duct and the auxiliary heating device.

15. The film forming device of any one of the preceding claims, configured to maintain a temperature inside the body of the chamber at about 250 °C to about 500 °C when a thin film is deposited on the substrate.
